(19) Europäisches Patentamt
European Patent Office
Office européen des brevets

(11) EP 4 700 415 A1

(12) EUROPÄISCHE PATENTANMELDUNG

(43) Veröffentlichungstag:
25.02.2026  Patentblatt 2026/09

(21) Anmeldenummer: 24195175.5

(22) Anmeldetag: 19.08.2024

(51) Internationale Patentklassifikation (IPC):
*G01R 31/52* (2020.01)

(52) Gemeinsame Patentklassifikation (CPC):
G01R 31/52

(84) Benannte Vertragsstaaten:
AL AT BE BG CH CY CZ DE DK EE ES FI FR GB
GR HR HU IE IS IT LI LT LU LV MC ME MK MT NL
NO PL PT RO RS SE SI SK SM TR
Benannte Erstreckungsstaaten:
BA
Benannte Validierungsstaaten:
GE KH MA MD TN

(71) Anmelder: Siemens Aktiengesellschaft
80333 München (DE)

(72) Erfinder:
• Schulze, Max
04938 Drasdo (DE)
• Schmidt, Uwe
01705 Freital (DE)

(74) Vertreter: Siemens Patent Attorneys
Postfach 22 16 34
80506 München (DE)

(54) **EVALUIEREN EINES ANOMALEN EREIGNISSES IN EINEM SCHWINGUNGSVERLAUF**

(57) Es wird ein Verfahren zum Evaluieren eines anomalen Ereignisses (150) bezüglich einem Schwingungsverlauf (100) beschrieben, das Verfahren aufweisend:
i) Definieren eines Zeitbereichs des Schwingungsverlaufs (100), der einen Scheitelwert-Bereich (110) aufweist, welcher beinhaltet:
ia) einen ersten Scheitelwert (111),
ib) einen zweiten Scheitelwert (112), der zeitlich auf den ersten Scheitelwert (111) folgt und im Vergleich zu dem ersten Scheitelwert abfallend ist, und
ic) einen dritten Scheitelwert (115), der zeitlich auf den zweiten Scheitelwert (112) folgt und im Vergleich zu dem zweiten Scheitelwert (112) ansteigend ist;

ii) Definieren einer einhüllenden Kurve (120) bezüglich dem Scheitelwert-Bereich (110);
iii) Bestimmen eines theoretischen Schwingungsverlaufs (140) bezüglich des dritten Scheitelwertes (115) basierend auf der einhüllenden Kurve (120);
iv) Vergleichen des theoretischen Schwingungsverlaufs (140) mit dem tatsächlichen Schwingungsverlauf (130) bezüglich dem dritten Scheitelwert (115), um eine Abweichung zu ermitteln; und
v) Evaluieren des anomalen Ereignisses (150) bezüglich dem Schwingungsverlauf (100) basierend auf der ermittelten Abweichung.

FIG 3

EP 4 700 415 A1

**Beschreibung**

Technisches Gebiet

Die Erfindung bezieht sich auf ein Verfahren zum Evaluieren eines anomalen Ereignisses bezüglich einem Schwingungsverlauf, das Verfahren aufweisend: Definieren eines Zeitbereichs des Schwingungsverlaufs, der einen Scheitelwert-Bereich aufweist, Definieren einer einhüllenden Kurve bezüglich dem Scheitelwert-Bereich, Bestimmen eines theoretischen Schwingungsverlaufs basierend auf der einhüllenden Kurve, Vergleichen des theoretischen Schwingungsverlaufs mit dem tatsächlichen Schwingungsverlauf, um eine Abweichung zu ermitteln, und Evaluieren des anomalen Ereignisses bezüglich dem Schwingungsverlauf basierend auf der ermittelten Abweichung. Die Erfindung betrifft weiterhin eine Vorrichtung zur Datenverarbeitung und eine Energievorrichtung, welche die Vorrichtung zur Datenverarbeitung aufweist.

Die Erfindung kann sich somit auf das technische Gebiet des Evaluierens von Schwingungsverläufen beziehen, insbesondere in Hinblick auf Erdschlüsse bei einer Energieanwendung wie z.B. Resonanz-Sternpunkt-Erdung.

Technischer Hintergrund

Schwingungsverläufe kommen in einer Vielzahl technischer Anwendungen vor; praktisch in allen physikalischen Bereichen, sowohl im elektrischen als auch im mechanischen oder optischen Bereich. Entsprechend wichtig können Evaluierungen dieser Schwingungsverläufe für unterschiedlichste Applikationen sein, sei es z.B. für Effizienzsteigerung oder Betriebssicherheit. In einem Schwingungsverlauf können jedoch unerwartete bzw. anormale Ereignisse auftreten, welche dann evaluiert werden müssen, z.B. hinsichtlich eines exakten Startpunkts des anomalen Ereignisses.

Im Folgenden wird das spezifische Beispiel einer Energieanwendung beschrieben, bei dem der Beginn eines Erdschluss bzw. einer Wiederzündung zu bestimmen ist. Jedoch ist eine Vielzahl weiterer Anwendungen des erfinderischen Prinzips denkbar und umsetzbar.

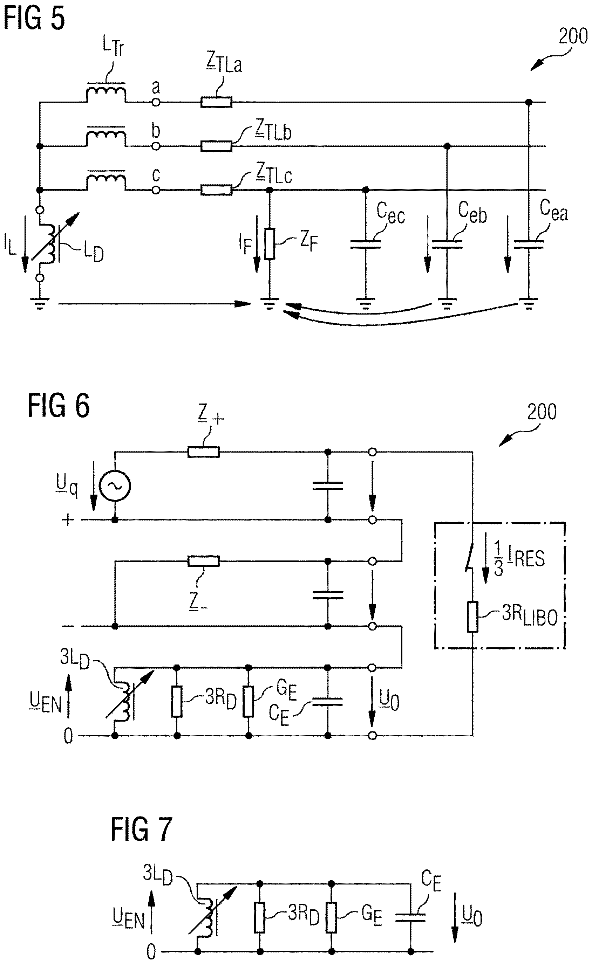

Ein Großteil der Fehler im Energieversorgungsnetz ist auf einpolige Fehler wie Erdschlüsse zurückzuführen. In nicht effektiv geerdeten Netzen mit Resonanz-Sternpunkt-Erdung (RESPE) bzw. Isoliertem Sternpunkt (OSPE) handelt es sich um Erdschlüsse, die zumeist einen Betrieb des fehlerbehafteten Netzes ermöglichen. Durch eine Löschspule im Sternpunkt eines bzw. mehrerer Transformatoren wird ein dem kapazitiven Erdschluss-Strom $I_{ce}$ entgegengesetzt wirkender induktiver Strom $I_L$ eingestellt. Es resultiert ein geringer Fehlerstrom, der die Berührungsspannungen an der Fehlerstelle begrenzt. Der Rest-Strom $I_{res}$ wird dabei wesentlich durch die Verstimmung und Dämpfung sowie harmonische Anteile bestimmt. Gleichzeitig treten in den intakten Leitern erhöhte Spannungen (quasistationär und transient) auf. **Figur** 5 zeigt ein anschauliches Beispiel einer bekannten Resonanz-Sternpunkt-Erdung-Vorrichtung 200 bei einem solchen Erdschluss.

Eine geringe Spannung an der Fehlerstelle und ein geringer Fehlerstrom führen z.T. zum selbstständigen Erlöschen des Erdschlusses. Nach Verlöschen des Erdschlusses kehrt die Leiter-Erde-Spannung wieder. Der Erdschluss stellt sich hierbei als Isolationsdurchbruch zwischen Leiter und Erde dar. Das vollständige Isolationsvermögen kann meist aber nicht vollständig erreicht werden; stattdessen kann das Isolationsvermögen der Leiter-Erde-Isolation an der Fehlerstelle dauerhaft reduziert sein. Die wiederkehrende Leiter-Erde-Spannung nach Erdschluss kann das Isolationsvermögen der Fehlerstelle überschreiten, so dass ein erneuter Erdschluss-Eintritt (Wiederzündung) die Folge ist.

In Netzen mit RESPE bzw. OSPE tritt dieser Vorgang ggf. mehrmals auf und wird als intermittierender Erdschluss bezeichnet. Dieser wirkt bis zur Abschaltung oder bis der Fehler stationär wird. **Figur** 6 zeigt anschaulich eine Ersatzschaltung eines intermittierenden Erdschlusses in einem symmetrischen Komponentensystem einer bekannten Resonanz-Sternpunkt-Erdung-Vorrichtung 200.

Ein Erdschlusseintritt kann z.B. drei Ausgleichsvorgänge bewirken:

- Entladevorgang der fehlerbehafteten Phase.
- Aufladevorgang der fehlerfreien Phasen,
- Spulenausgleichsvorgang.

Die Vorgänge können sich in allen Abgängen in Strom und Spannung auswirken. Nach Ende der Ausgleichsvorgänge kann der Erdschluss in einen stationären Fehler übergehen. Kommt es selbstständig oder durch Abschaltung zum Verlöschen des Erdschlusses, reduziert sich die Nullspannung über einen Ausgleichsvorgang. Die Schwingung des Resonanzkreises im Nullsystem kann für einen Erdschluss in Leiter a auf bekannte Weise beschrieben werden. **Figur** 7 zeigt anschaulich einen Resonanzkreis in einem Nullsystem einer bekannten Resonanz-Sternpunkt-Erdung-Vorrichtung 200.

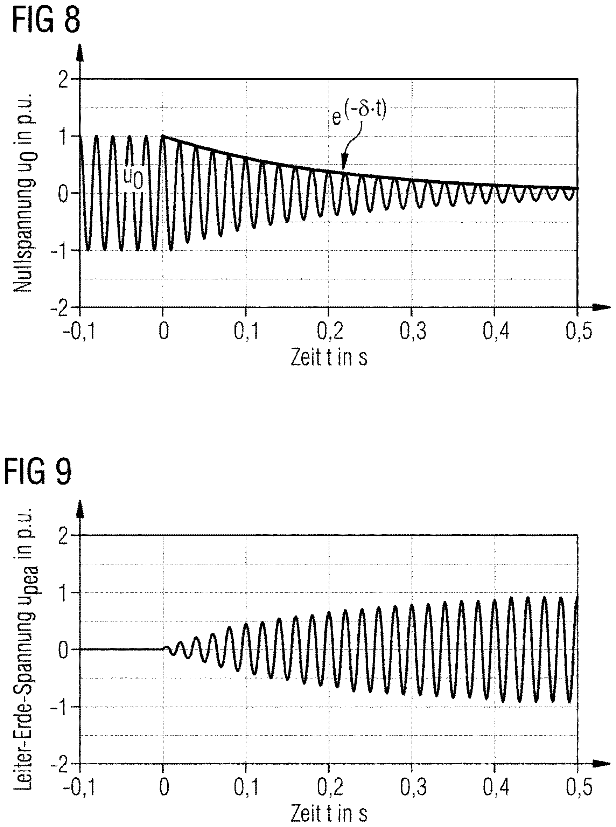

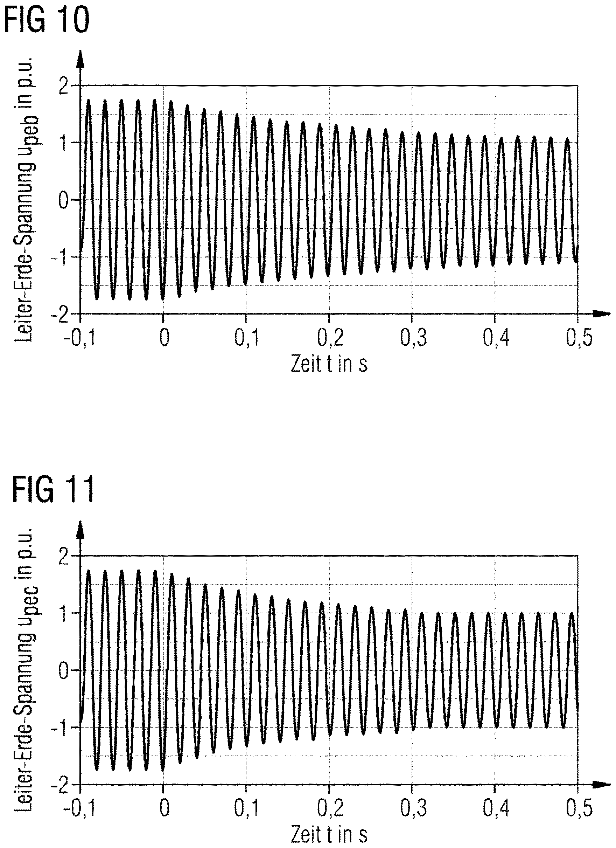

**Figur** 8 zeigt einen Nullspannung-Schwingungsverlauf bei Verstimmung v = 1% und Dämpfung d = 3%. **Figuren 9 bis 11** zeigen das Verhalten einer Leiter-Erde-Spannung nach Verlöschen eines Erdschlusses bei Verstimmung v = 1% und Dämpfung d = 3%. Durch die gedämpfte Schwingung im Nullsystem wächst die Leiter-Erde-Spannung der fehlerbehafteten Phase langsam an. Die durchbrochene Isolationsstrecke kann sich ggf. wiederverfestigen. Dieser Effekt kann die Fehlerklärung in RESPE-Netzen begünstigen. Erlangt die Isolationsstrecke ihre volle Spannungsfestigkeit nicht wieder, führt die ansteigende Leiter-Erde-Spannung zu einer Wiederzündung. Bei mehrfacher Wiederzündung handelt es sich um einen intermittierenden Erdschluss.

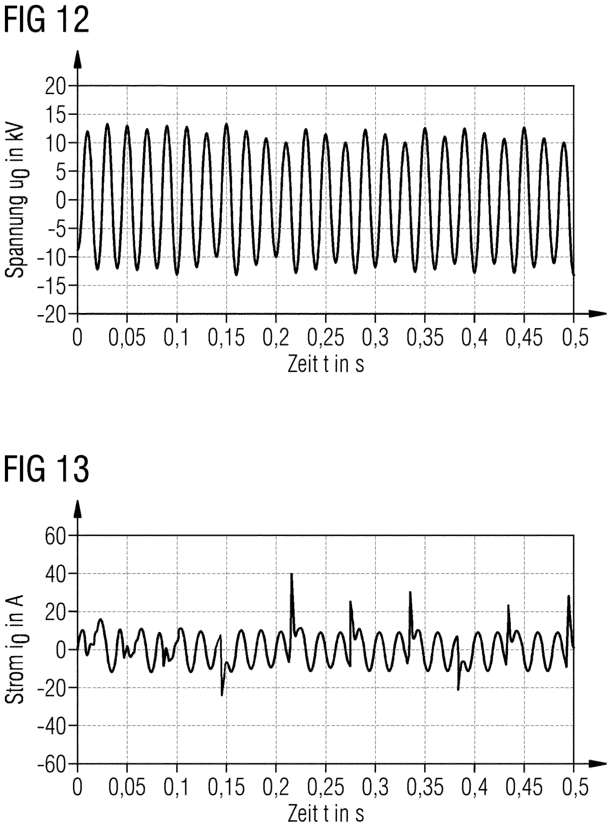

**Figur 12** zeigt einen Nullspannung-Schwingungsverlauf eines wiederzündenden Erdschlusses und **Figur 13** zeigt einen korrespondierenden Nullstrom-Schwingungsverlauf.

Zur Auswertung des Erdschlusses werden allgemein Strom und Spannung des Nullsystems im Augenblick des Erdschlusseintritts bzw. im stationären Fehlerzustand ausgewertet. Die Erfassung des Nullstromes erfolgt je Abgang z.B. direkt über eine Holmgreen-Schaltung oder einen Kabelumbau-Wandler. Die Nullspannung kann z.B. über eine offene Dreieckswicklung je Abgang, jedoch mindestens an der Sammelschiene, gemessen werden. Alternativ erfolgt die Ermittlung von Nullstrom und -Spannung z.B. über die bekannten Ausdrücke:

$$i_0 = 1/3 \, (i_a + i_b + i_c), \quad u_0 = 1/3 \, (u_a + u_b + u_c).$$

Jede Wiederzündung stellt für das Netz eine Spannungsbelastung dar, insbesondere für die am Fehler nicht beteiligten Leiter. Die Spannungsbelastung (Überspannung) kann im Verlauf des Fehlers zu Doppelerdschlüssen führen. Weiterhin kann an der Fehlerstelle eine mögliche Berührungsspannung resultieren, die zu einer Personengefährdung führen kann.

Um den aktiven Eingriff zu ermöglichen bzw. den fehlerbehafteten Abgang zu identifizieren, kann es notwendig sein, ein Fehlerstrom-Ereignis (Erdschluss bzw. Wiederzündung) zuverlässig zu identifizieren bzw. exakte Zeitpunkte wie Beginn und/oder Ende des Fehlerstrom-Ereignisses zu bestimmen. Eine effiziente und zuverlässige Ermittlung kann jedoch herausfordernd sein.

Zusammenfassung der Erfindung

Es kann ein Bedarf bestehen, einen Schwingungsverlauf hinsichtlich eines anomalen Ereignisses effizient und zuverlässig zu evaluieren.

Ein Verfahren, eine Vorrichtung zur Datenverarbeitung, und eine Energievorrichtung werden im Folgenden beschrieben.

Gemäß einem ersten Aspekt der Erfindung wird ein (insbesondere Computer-implementiertes) Verfahren zum Evaluieren eines anomalen/unerwarteten Ereignisses (z.B. ein Erdschluss bzw. eine Wiederzündung) bezüglich einem Schwingungsverlauf (z.B. ein elektrischer/mechanischer/optischer Schwingungsverlauf) beschrieben, das Verfahren aufweisend:

i) Definieren eines (bestimmten/spezifischen) Zeitbereichs des Schwingungsverlaufs, der einen Scheitelwert-Bereich (insbesondere einen Bereich mit einer Mehrzahl von Scheitelwerten; weiter insbesondere lokalen Maxima/-Minima) aufweist, welcher beinhaltet:

ia) einen ersten Scheitelwert,
ib) einen zweiten Scheitelwert, der zeitlich (direkt oder mit weiteren Scheitelwerten dazwischen) auf den ersten Scheitelwert folgt und im Vergleich zu dem ersten Scheitelwert abfallend (geringer/niedriger/kleiner) ist, und
ic) einen dritten Scheitelwert, der zeitlich auf den zweiten Scheitelwert folgt und im Vergleich zu dem zweiten Scheitelwert ansteigend (höher, größer) ist;

ii) insbesondere Definieren einer einhüllenden Kurve (insbesondere eine Kurve, welche die Scheitelwerte verbindet, die einhüllende Kurve kann auch eine Gerade sein) bezüglich dem Scheitelwert-Bereich (insbesondere bezüglich dem ersten Scheitelwert und dem zweiten Scheitelwert);
iii) Bestimmen eines theoretischen (berechneten, simulierten, modellierten) Schwingungsverlaufs bezüglich des dritten Scheitelwertes (insbesondere basierend auf der einhüllenden Kurve) (z.B. Berechnen einer harmonischen Schwingung);
iv) Vergleichen des theoretischen Schwingungsverlaufs mit dem tatsächlichen (gemessenen) Schwingungsverlauf bezüglich dem dritten Scheitelwert (z.B. Bilden einer Differenz), um eine Abweichung zu ermitteln; und
v) Evaluieren des anomalen Ereignisses (z.B. präzises Ermitteln eines Zeitpunkts) bezüglich dem Schwingungsverlauf basierend auf der ermittelten Abweichung.

Gemäß einem zweiten Aspekt der Erfindung wird eine Vorrichtung zur Datenverarbeitung (z.B. ein oder mehr Prozessoren) beschrieben, die eingerichtet ist das Verfahren wie oben beschrieben (zumindest teilweise) auszuführen.

Gemäß einem dritten Aspekt der Erfindung wird eine Energievorrichtung beschrieben (z.B. eine Resonanz-Sternpunkt-Erdung-Vorrichtung), insbesondere aufweisend zumindest ein Schutzgerät, wobei die Energievorrichtung zumindest eine Vorrichtung zur Datenverarbeitung wie oben beschrieben aufweist.

Im vorliegenden Kontext kann der Begriff "Schwingungsverlauf" insbesondere darstellen, wie sich eine Schwingungsgröße im Laufe der Zeit verändert. Ein Schwingungsverlauf kann eine wiederholte/periodische zeitliche Schwankung der Schwingungsgröße darstellen und eine Mehrzahl von Schwellwerten wie Maxima und Minima aufweisen. Die Schwingungsgröße kann eine physikalische Größe sein, z.B. eine elektrische Größe wie Spannung, Strom, oder Energie. Die Schwingungsgröße kann auch eine mechanische Größe wie z.B. eine Feder sein. Fern kann die Schwingungsgröße auch eine optische Größe wie z.B. der Verlauf einer elektromagnetischen Welle sein.

Im vorliegenden Kontext kann der Begriff "Scheitelwert" insbesondere einen Wert eines Schwingungsverlaufs bezeichnen, der einen lokalen Extremwert, z.B. ein lokales Maximum oder ein lokales Minimum darstellt. Bei einem Schwingungsverlauf liegen gewöhnlich, aufgrund der Periodizität, eine Vielzahl von Scheitelwerten vor. Der Begriff "Scheitelwert-Bereich" kann entsprechend einen Bereich des Schwingungsverlaufs (insbesondere in dem definierten Zeitbereich) bezeichnen, in welchem eine Mehrzahl (insbesondere zumindest drei) Scheitelwerte vorliegen. In einem bevorzugten Ausführungsbeispiel weist ein Scheitelwert-Bereich zumindest drei zeitlich aufeinanderfolgende Scheitelwerte auf, wobei der mittlere Scheitelwert geringer ist als der erste und der dritte Scheitelwert. In einem Ausführungsbeispiel sind der erste Scheitelwert und der zweite Scheitelwert Teil eines Ausschwingvorgangs, wobei der dritte Scheitelwert diesen unterbricht und Teil eines anomalen Ereignisses (insbesondere einer Wiederzündung) ist.

Gemäß einem exemplarischen Ausführungsbeispiel kann die Erfindung auf der Idee basieren, dass ein Schwingungsverlauf hinsichtlich eines anomalen Ereignisses effizient und zuverlässig evaluiert werden kann, wenn ein Zeitbereich des Schwingungsverlaufs definiert wird (der mit dem anomalen Ereignis assoziiert ist), ein Scheitelwert-Bereich definiert wird, der den Übergang von einem Ausschwingvorgang zu dem anomalen Ereignis darstellt, und ein Vergleich angestellt wird zwischen dem tatsächlichen Verlauf des Ereignis-Scheitelwerts und einem theoretischen Verlauf (berechnet basierend auf einer einhüllenden Kurve) des Ereignis-Scheitelwerts. Es hat sich überraschend gezeigt, dass anhand dieses einfaches und effizienten Ansatzes das anomale Ereignis sehr zuverlässig charakterisiert werden kann. Insbesondere kann das anomale Ereignis zuverlässig als solches bestätigt werden und/oder bestimmte Zeitpunkte wie der genaue Eintritt des anomalen Ereignisses können ermittelt werden.

Exemplarische Ausführungsbeispiele

Gemäß einem Ausführungsbeispiel weist das Evaluieren auf: Vergleichen der ermittelten Abweichung mit einem Schwellwert, insbesondere Grenzwert. Dadurch kann in einfacher und effizienter Weise die Abweichung ausgewertet werden. In einem Ausführungsbeispiel kann z.B. der Betrag der Differenz/Änderung mit einem Schwellwert ($u_{0\ thres}$) verglichen werden, z.B.

$$|\Delta u(t)| > u_{0\ thres.}$$

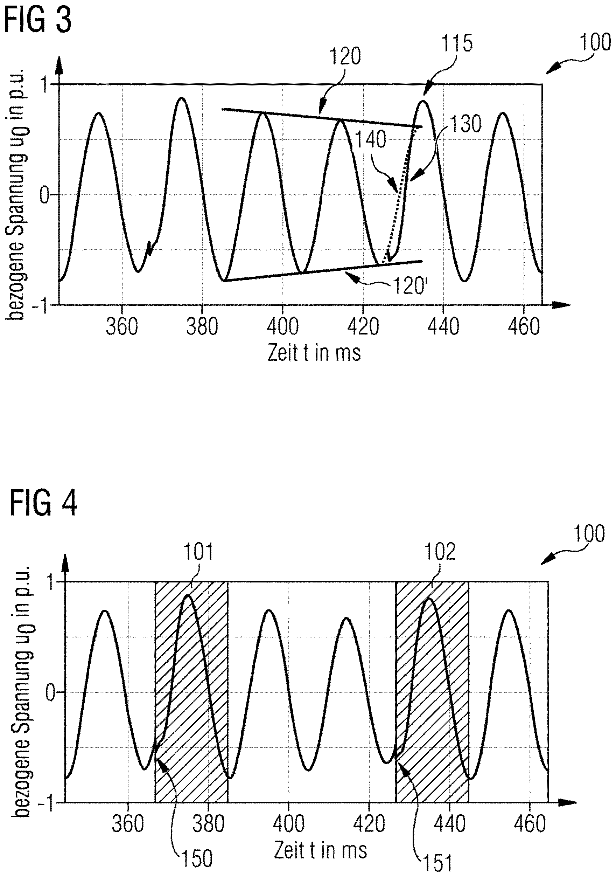

Gemäß einem Ausführungsbeispiel weist das Evaluieren ferner auf: Bestimmen eines Zeitbereichs, insbesondere Zeitpunkts, an dem die ermittelte Abweichung den Schwellwert übersteigt, als Beginn des anomalen Ereignisses. Dies kann den Vorteil haben, dass er Zeitpunkt von Interesse präzise bestimmt werden kann. In einem Ausführungsbeispiel kann der (erste) Zeitpunkt, ab dem die Differenz den Schwellwert übersteigt, als Zeitpunkt des anomalen Ereignisses (z.B. Wiederzündung) $t_{rs}$ definiert werden. Zusätzlich können bei Bedarf die Zeitpunkte der signifikanten Scheitelwerte durch einen Algorithmus bereitgestellt werden. Beispielsweise Figur 4 kennzeichnet den Zeitraum von Wiederzündung $t_{rs}$ bis zum Beginn des Ausschwingvorgangs $t_n$.

Gemäß einem Ausführungsbeispiel weist das Vergleichen auf: Bilden einer Differenz zwischen dem theoretischen Schwingungsverlauf und dem tatsächlichen Schwingungsverlauf. Damit können die Schwingungsverläufe effizient verglichen werden. In einem Ausführungsbeispiel erfolgt ein Abgleich der gemessenen Nullspannung $u_0(t)$ mit dem modellierten Verlauf $u_{est}(t)$ (siehe detailliert unten). Aus beiden Verläufen kann im fraglichen Zeitbereich t Element von $[t_n, t_n + n_T{*}T]$ die Differenz ermittelt werden:

$$\Delta u(t) = u_{est}(t) - u_0(t).$$

In einem Ausführungsbeispiel führt eine Wiederzündung zu einer Änderung der Nullspannung $u_0(t)$ und damit zum Anstieg der Differenz $\Delta u(t)$.

Gemäß einem Ausführungsbeispiel betrifft die Schwingungskurve eine elektrische Größe. Gemäß einem Ausführungsbeispiel betrifft die Schwingungskurve eine Nullspannung und/oder einen Nullstrom. Insbesondere die Nullspannung kann besonders geeignet für die beschriebene Analyse des Schwingungsverlaufs sein.

Gemäß einem Ausführungsbeispiel wird der tatsächliche Schwingungsverlauf gemessen, insbesondere experimentell bestimmt. Beispielsweise kann der Verlauf der Nullspannung erfasst werden.

Gemäß einem Ausführungsbeispiel betreffen der theoretische Schwingungsverlauf und der tatsächliche Schwingungsverlauf eine Steigung. Insbesondere kann die Steigung des dritten Scheitelwerts zum Evaluieren des anomalen Ereignisses analysiert werden.

Gemäß einem Ausführungsbeispiel sind der erste Scheitelwert und der zweite Scheitelwert Teil eines Ausschwingvorganges. Gemäß einem Ausführungsbeispiel unterbricht der dritte Scheitelwert den Ausschwingvorgang.

Gemäß einem Ausführungsbeispiel weist der Scheitelwert-Bereich eine Mehrzahl von in zeitlicher Reihenfolge abfallender Scheitelwerte auf. Durch eine Mehrzahl von Scheitelwerten kann die Genauigkeit (insbesondere der einhüllenden Kurve) verbessert werden.

Gemäß einem Ausführungsbeispiel wird das Definieren der einhüllenden Kurve bezüglich des ersten Scheitelwerts und des zweiten Scheitelwerts durchgeführt (insbesondere bezüglich weiterer Scheitelwerte dazwischen). Gemäß einem Ausführungsbeispiel wird das Definieren der einhüllenden Kurve frei von dem dritten Scheitelwert ausgeführt.

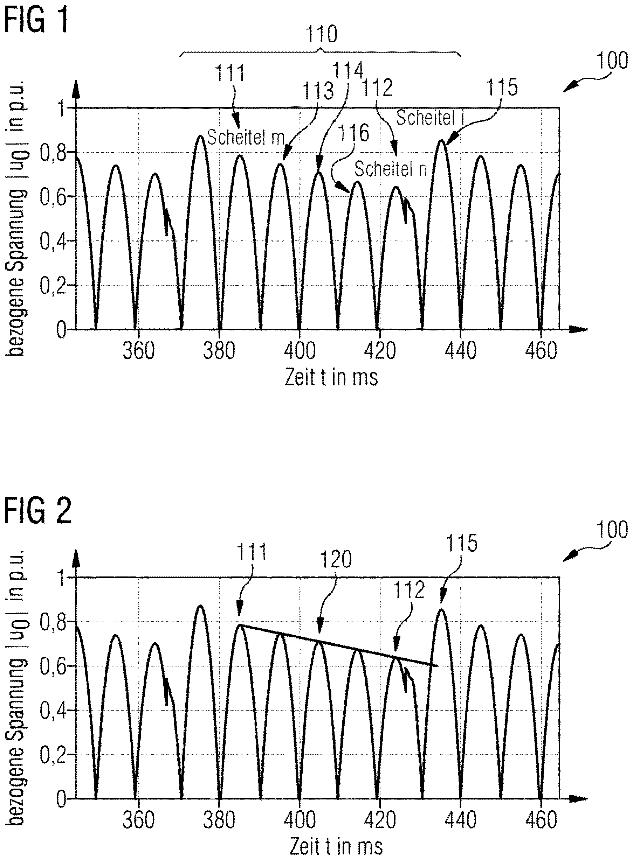

In einem Ausführungsbeispiel wird auf Basis der ermittelten Zeitpunkte (Scheitelwerte) die den Ausschwingvorgang, z.B. der Nullspannung, kennzeichnen, die Hüllkurve ermittelt. Aus den Beträgen und Zeitpunkten der m-ten und n-ten-Scheitelwerte (vergleiche Figur 1) kann z.B. die Zeitkonstante $\tau$ ermittelt werden. Nachfolgende Ermittlungsschritte werden mit zeitkontinuierlichen Ausdrücken erläutert. Gleichermaßen ergibt sich daraus auch eine zeitdiskrete Anwendung.

$$\tau = 1/\delta = (t_n - t_m) / ( \ln|\hat{u}_{0\,m}| - \ln|\hat{u}_{0\,n}| ).$$

Mit der Zeitkonstante $\tau$ kann in einem Ausführungsbeispiel die Hüllkurve $u_{env}(t)$ durch die Scheitelwerte der Nullspannung beschrieben werden. Die Berechnung erfolgt vom m-ten Scheitelwertes mit $t = 0$ bis zum n-ten Scheitelwert und mindestens einer weiteren Periode der Netzfrequenz T.

Aufgrund innerer Asymmetrien und äußerer Einkopplungen kann es zu Schwebungen der Nullspannung und einem zeitlichen Versatz kommen, der größer als eine Periodendauer ist. Hier kann der zu betrachtende Zeitbereich erweitert werden und mindestens bis zum Zeitpunkt $t_i$ verlängert werden. Es wird z.B. ein ganzzahliger Faktor $\eta_\tau$ verwendet, der ein Vielfaches von T definieren kann (wobei $\eta_\tau$ eine natürliche Zahl ist):

$$n_T \geq (t_i - t_n) / T.$$

Aufgrund der Eigenschaft des n-ten Scheitelwertes (zweiter Scheitelwert) als Kennzeichnung für den letzten Scheitel vor Erdschluss/Wiederzündung kann davon ausgegangen werden, dass es innerhalb der nächsten Periode zur Wiederzündung kommt:

$$u_{env}(t) = |\hat{u}_{0\,m}| * e^{((t-tm)/\tau)} \quad \text{mit t Element von } [t_m, t_n + n_T*T].$$

Gemäß einem Ausführungsbeispiel weist das Bestimmen des theoretischen Schwingungsverlaufs auf: Berechnen eines, insbesondere harmonischen, Verlaufs zeitlich nach dem zweiten Scheitelwert. Gemäß einem Ausführungsbeispiel wird für das Bestimmen des theoretischen Schwingungsverlaufs zumindest eine der folgenden Frequenzen zum Berechnen verwendet: Netzfrequenz, Netznennfrequenz, Eigenfrequenz der Nullspannung.

In einem Ausführungsbeispiel kann der Zeitpunkt der Wiederzündung bei Überschreiten der Hüllkurve z.B. durch die Nullspannung bestimmt werden. Jedoch kann eine Wiederzündung auch zu einzelnen geringen Scheitelwerten führen. Um die Wiederzündung dennoch geeignet zu erfassen, kann der (theoretische) Verlauf der Nullspannung modelliert werden. Beispielsweise beginnend vom letzten Scheitelwert (zweiter Scheitelwert) vor Zündung (Index n) kann ein Cosinus-Verlauf berechnet werden. Die Anwendung der Netznennfrequenz $f_n$ kann z.B. hinreichend genau sein. Alternativ kann auch die Eigenfrequenz der Nullspannung $f_{e\,0}$ oder die aktuelle Netzfrequenz verwendet werden. Die Amplitude wird durch die Hüllkurve $u_{env}(t)$ vorgeben. Der theoretische Verlauf bezüglich des dritten Scheitelwerts kann z.B. wie folgt bestimmt werden:

$$u_{est}(t) = u_{env}(t) * \cos(2*\pi*f_n*(t-t_m)) \quad \text{mit t Element von } [t_n, t_n+n_T*T].$$

Bisher wurde der Ausgleichsvorgang im Nullsystem vorzeichenunabhängig berücksichtigt. In Bezug auf den theoretischen/modellierten Nullspannungsverlauf $u_{est}(t)$ kann zusätzlich das Vorzeichen des n-ten Scheitelwertes betrachtet werden (siehe z.B. Figur 3). Der Vektor des modellierten Nullspannungsverlaufs $u_{est}(t)$ kann z.B. folgendermaßen angepasst werden:

$$u_{est}(t) = sign(\hat{u}_{0\,n}) * u_{est}(t).$$

Gemäß einem Ausführungsbeispiel weist das anomale Ereignis ein Fehlerstrom-Ereignis, insbesondere ein Erdschluss-Ereignis, weiter insbesondere ein Wiederzündung-Ereignis, auf. Gemäß einem Ausführungsbeispiel weist das Verfahren auf: Ermitteln einer Mehrzahl von aufeinanderfolgenden Wiederzündung-Ereignissen, insbesondere Bestätigen dieser Ereignisse und/oder Ermitteln von zumindest einem der folgenden: Zeitpunkt, Zeitbereich, Startpunkt, Endpunkt.

Gemäß einem Ausführungsbeispiel wird das Verfahren bezüglich einer Erdung, insbesondere einer Sternpunkt-Erdung, weiter insbesondere einer Resonanz-Sternpunkt-Erdung, verwendet.

Gemäß einem exemplarischen Ausführungsbeispiel wird von einem Erdschluss in Netzen mit Resonanzsternpunkterdung ausgegangen. Dabei kann die Nullspannung direkt erfassen werden oder z.B. über die Leiter-Größen ermittelt werden. Der Erdschluss ist nicht stationär und nach Abklingen der transienten Anteile im Fehlerstrom erlischt der Fehlerlichtbogen selbstständig; es resultiert ein bekannter Ausgleichsvorgang. Erfindungsgemäß können z.B. die folgenden Schritte vorgenommen werden:

i) Bewertung der Scheitelwerte und Kennzeichnung der Scheitelwerte, die folgende Eigenschaften aufweisen:

a) Scheitelwerte bei aktivem Erdschluss bzw. nach Wiederzündung (dritter Scheitelwert).
b) Scheitelwerte zu Beginn und Ende des Ausschwingvorgangs der Nullspannung (zumindest erster und zweiter Scheitelwert).

ii) Ermittlung der Wiederzündzeitpunkte über Auswertung der Differentialgleichung und Nachbildung des (theoretischen) Nullspannungsverlaufs.

Gemäß einem Ausführungsbeispiel wird der Ausschwingvorgang der Nullspannung durch die Netzparameter und Betriebsbedingungen beeinflusst und kann auf bekannte Weise berechnet werden. Abweichungen davon sind möglich und verweisen auf transiente Vorgänge abseits des Ausschwingvorgangs. Es kann daher dienlich sein, transiente Scheitelwerte auszuschließen. Zur Differenzierung kann eine Vergleichsgröße eingeführt werden. Dies erfolgt z.B. auf Basis einer Abschätzung der maximal zu entwertenden Differenz zweier Spannungsscheitelwerte. Es werden z.B. eine maximale Dämpfung $d_{max}$ (geeignet z.B. $d_{max} = 7\%$) und eine maximale Verstimmung $v_{max}$ (geeignet z.B. $v_{max} = 15\,\%$) zur Berechnung verwendet. Bei genauer Netzkenntnis können die Maximalwerte auch reduziert bzw. angepasst werden:

$$\Delta u_{max} = 1 - e^{\wedge}\,(-\,(1)\,/\,(2*f_n*\tau_{min}))\ \text{in p.u.}$$

Zur Bewertung des Ausgleichsvorgangs der Nullspannung wird in einem Ausführungsbeispiel dessen Betrag $|u_o|$ verwendet. Ausgehend vom Betrag der Nullspannung werden die Scheitelwerte mit ihrem Scheitelwert und dem Zeitpunkt ermittelt. Es ergibt sich jeweils ein Vektor mit k Scheitelwerten und k Zeitpunkten. Bei einer Wiederzündung ist eine signifikante Folge von Spannungsscheitelwerten vorhanden. Vor einer Wiederzündung muss der vorhergehende Erdschluss verloschen sein und das Nullsystem einen Ausschwingvorgang aufweisen. Damit tritt vor Zündung ein (zweiter) Scheitelwert (Index n) der Nullspannung auf, der im Bezug zu den umliegenden Scheitelwerten am kleinsten ist. Einer der umliegenden Scheitelwerte muss in diesem Beispiel größer sein als ein einstellbarer bezogener Schwellwert $u_{0\,thres}$, wie er auch zur Feststellung eines Erdschlusses Anwendung findet, z.B. $|\hat{u}_{0\,k}| > u_{0\,thres} * U_s * (\sqrt{2}\,/\,\sqrt{3})$ mit k Element von [n-2, n+2].

In einem Ausführungsbeispiel erfolgt die Identifikation des Scheitelwertes, der den signifikanten Scheitelwert und die Wiederzündung kennzeichnet. Dieser ist kleiner als der vorangehende Scheitelwert. Zusätzlich soll eine Folge von Scheitelwerten einen abnehmenden/abfallenden Spannungsbetrag aufweisen. Als praktisch werden zwei vorangehend abnehmende Scheitelwerte angesehen. Mit dem kennzeichnenden kleinsten Scheitelwert ergeben sich drei aufeinanderfolgend abnehmende Scheitelwerte. Nach dem kleinsten Scheitelwert erfolgt i.d.R. eine Wiederzündung, die zu einem Anstieg der Nullspannung führt. Der nachfolgende Scheitelwert muss daher größer sein. Ausgehend von einer Folge von k Scheitelwerten muss für den n-ten Scheitelwert und der Scheitelwerte in der Umgebung folgende Bedingung zur Identifikation erfüllt sein:

$$|\hat{u}_{0\,n}| < |\hat{u}_{0\,n-1}|$$

$$|\hat{u}_{0\,n-1}| < |\hat{u}_{0\,n-2}|$$

$$|\hat{u}_{0\,n}| < |\hat{u}_{0\,n+1}|$$

Hieraus kann bereits ein intermittierender Erdschluss erkannt werden.

In einem Ausführungsbeispiel können sich bei stationären Erdschlüssen die Scheitelwerte der Nullspannung auch geringfügig unterscheiden und die Bedingung von $u_{max}$ (siehe oben) erfüllen. Diese kennzeichnen jedoch nicht zwingend einen intermittierenden Erdschluss. Der Ausschwingvorgang des Nullsystem ist durch seine Betriebsgrößen bestimmt. Die Scheitelwerte sollten damit eine Mindestdifferenz aufweisen. Als praktisch kann eine bezogene Differenz zu $\Delta u_{min} = 0{,}01$ p.u. angenommen werden und auf den n-ten Scheitelwert bezogen werden:

$$|\hat{u}_{0\,n-1}| - |\hat{u}_{0\,n}| > |\hat{u}_{0\,n}| * \Delta u_{min}.$$

$$|\hat{u}_{0\,n+1}| - |\hat{u}_{0\,n}| > |\hat{u}_{0\,n}| * \Delta u_{min}.$$

In einem Ausführungsbeispiel kann in Abhängigkeit des Zeitpunktes der Wiederzündung der geringste Scheitelwert bereits durch die Wiederzündung beeinflusst sein. Da der n-te Scheitelwert in der Evaluation Anwendung findet, soll dieser noch zum Ausschwingvorgang gehören. Die Differenz zwischen dem n-ten und (n-1)-ten Scheitelwert ist begrenzt Es erfolgt z.B. ein Abgleich der Differenz mit einer maximal anzunehmenden Differenz unter Verwendung von $\Delta u_{max}$:

$$|\hat{u}_{0\,n-1}| - |\hat{u}_{0\,n}| > |\hat{u}_{0\,n-1}| * \Delta u_{max}.$$

Handelt es sich in einem Ausführungsbeispiel hingegen um einen transienten Scheitelwert, kann der vorhergehende Scheitelwert n-1 auf Eignung zu prüfen sein. Vor diesem müssen noch zwei weitere Scheitelwerte existieren, die einen fallenden Verlauf darstellen:

$$|\hat{u}_{0\,n-1}| < |\hat{u}_{0\,n-2}|.$$

$$|\hat{u}_{0\,n-2}| < |\hat{u}_{0\,n-3}|.$$

In einem Ausführungsbeispiel wird die Position des n-ten Scheitelwertes (bzw. (n-1), im Weiteren nur als n-ter Scheitelwert) im Vektor der Scheitelwerte gespeichert. Ausgehend von der Position des n-ten Scheitelwertes kann ein erster Scheitelwert (Index m) bestimmt werden, der den Beginn des Ausschwingvorgangs kennzeichnet. Da der Bereich um den n-ten Scheitelwert bereits auf einen signifikanten Verlauf geprüft wurde, wird für den m-ten Scheitelwert folgende Bedingung angenommen:

$$|\hat{u}_{0\,m}| > |\hat{u}_{0\,m-1}|.$$

Zusätzlich darf zum nachfolgenden Scheitelwert nur eine maximal zulässige Differenz existieren:

$$|\hat{u}_{0\,m}| - |\hat{u}_{0\,m-1}| < |\hat{u}_{0\,m}| * \Delta u_{max}.$$

Ist die Bedingung in einem Ausführungsbeispiel erfüllt, wird die Position des m-ten Scheitelwerts gespeichert. Ist diese hingegen nicht erfüllt, handelt es sich um einen transienten Scheitelwert, der den Ausschwingvorgang nicht kennzeichnet. In diesem Fall wird die Position des (m-1)-ten Scheitelwerts verwendet. Nach dem n-ten Scheitelwert kommt es zur Wiederzündung des Erdschlusses und zum Anstieg der folgenden Scheitelwerte. Der Anstieg kann dabei über mehrere Scheitelwerte oder unverzüglich erfolgen. Kennzeichnend ist der maximale Scheitelwert (Index i). Für den i-ten Scheitelwert werden folgende Bedingungen angenommen:

$$|\hat{u}_{0\,i}| > |\hat{u}_{0\,i-1}|.$$

$$|\hat{u}_{0\,i}| > |\hat{u}_{0\,i+1}|.$$

$$|\hat{u}_{0\,i}| > u_{0\,thres} * U_s * (\sqrt{2} / \sqrt{3}).$$

In einem Ausführungsbeispiel sind im Ergebnis dann zumindest drei signifikante Scheitelwerte der Reihenfolge m, n und i identifiziert, die eine Wiederzündung eindeutig kennzeichnen und zur weiteren Auswertung verwendet werden (siehe auch Figur 1).

Es ist zu beachten, dass Ausführungsformen der Erfindung unter Bezugnahme auf verschiedene Gegenstände beschrieben wurden. Insbesondere wurden einige Ausführungsformen unter Bezugnahme auf Verfahrensansprüche beschrieben, während andere Ausführungsformen unter Bezugnahme auf Vorrichtungsansprüche beschrieben wurden. Ein Fachmann wird jedoch aus dem Vorstehenden und der folgenden Beschreibung entnehmen, dass, sofern nicht anders angegeben, neben jeder Kombination von Merkmalen, die zu einer Art von Gegenstand gehören, auch jede Kombination von Merkmalen, die sich auf verschiedene Gegenstände beziehen, als von diesem Dokument offenbart gilt. Dies gilt insbesondere auch zwischen Merkmalen der Verfahrensansprüche und Merkmalen der Vorrichtungsansprüche.

Die oben definierten Aspekte und weitere Aspekte der vorliegenden Erfindung ergeben sich aus den nachstehend zu beschreibenden Beispielen der Ausführungsformen und werden unter Bezugnahme auf die Beispiele der Ausführungsformen erläutert. Die Erfindung wird im Folgenden unter Bezugnahme auf Ausführungsformen, auf die die Erfindung jedoch nicht beschränkt ist, näher beschrieben.

Kurze Beschreibung der Zeichnungen

Figur 1 zeigt einen Nullspannung-Schwingungsverlauf mit einem Scheitelwert-Bereich und einem anomalen Ereignis, gemäß einem exemplarischen Ausführungsbeispiel der Erfindung.

Figur 2 zeigt eine einhüllende Kurve, die bezüglich des Scheitelwert-Bereichs bestimmt wird, gemäß einem exemplarischen Ausführungsbeispiel der Erfindung.

Figur 3 zeigt das Bestimmen eines theoretischen Schwingungsverlaufs basierend auf der einhüllenden Kurve, gemäß einem exemplarischen Ausführungsbeispiel der Erfindung.

Figur 4 zeigt einen Nullspannung-Schwingungsverlauf mit definierten Zeitbereichen anomaler Ereignisse, gemäß einem exemplarischen Ausführungsbeispiel der Erfindung.

Figur 5 zeigt eine Resonanz-Sternpunkt-Erdung-Vorrichtung bei einem Erdschluss.

Figur 6 zeigt eine Ersatzschaltung eines intermittierenden Erdschlusses in einem symmetrischen Komponentensystem einer Resonanz-Sternpunkt-Erdung-Vorrichtung.

Figur 7 zeigt einen Resonanzkreis in einem Nullsystem einer Resonanz-Sternpunkt-Erdung-Vorrichtung.

Figur 8 zeigt einen Nullspannung-Schwingungsverlauf bei Verstimmung und Dämpfung.

Figuren 9 bis 11 zeigen das Verhalten einer Leiter-Erde-Spannung nach Verlöschen eines Erdschlusses bei Verstimmung und Dämpfung.

Figur 12 zeigt einen Nullspannung-Schwingungsverlauf eines wiederzündenden Erdschlusses und Figur 13 zeigt einen korrespondierenden Nullstrom-Schwingungsverlauf.

Detaillierte Beschreibung der Zeichnungen

Die Darstellung in den Zeichnungen sind schematisch. Es wird darauf hingewiesen, dass in unterschiedlichen Abbildungen ähnliche oder identische Elemente oder Merkmale mit den gleichen Bezugszeichen oder mit Bezugszeichen versehen sind, die sich von den entsprechenden Bezugszeichen nur innerhalb der ersten Ziffer unterscheiden. Um unnötige Wiederholungen zu vermeiden, werden Elemente oder Merkmale, die bereits in Bezug auf eine zuvor beschriebene Ausführungsform erläutert wurden, an einer späteren Stelle der Beschreibung nicht noch einmal erläutert.

Darüber hinaus werden räumlich relative Begriffe wie "vorne" und "hinten", "oben" und "unten", "links" und "rechts" usw. verwendet, um die Beziehung eines Elements zu einem anderen Element zu beschreiben, wie in den Abbildungen dargestellt. So können die räumlich relativen Begriffe auf verwendete Orientierungen zutreffen, die von der in den Abbildungen dargestellten Orientierung abweichen. Offensichtlich beziehen sich diese räumlich relativen Begriffe lediglich auf eine Vereinfachung der Beschreibung und die in den Abbildungen gezeigte Orientierung und sind nicht notwendigerweise einschränkend, da eine Vorrichtung gemäß einer Ausführungsform der Erfindung andere Orientierungen als die in den Abbildungen dargestellten annehmen kann, insbesondere wenn sie verwendet wird.

Bevor die Zeichnungen im Detail beschrieben werden, wird im Folgenden anschaulich ein exemplarisches Ausführungsbeispiel der Erfindung beschrieben.

Bei diesem exemplarischen Ausführungsbeispiel werden eine Wiederzündung bei einer Resonanz-Sternpunkt-Erdung und deren Zeitpunkte direkt aus der aufgenommenen Nullsystem-Spannung ermittelt. Der intermittierende Fehler wird durch einfache Vergleichsbedingungen zwischen mehreren Scheitelwerten der Nullspannung erkannt. Damit wird einer Überempfindlichkeit entgegengewirkt. Der dadurch ausgeblendete Bereich einer wiederkehrenden Spannungsfestigkeit umfasst wenige Prozent. Die Bewertung der Scheitelwerte der Nullspannung erfolgt vorzeichenunabhängig für den Betrag der Nullsystem-Spannung. Die Scheitelwerte werden anhand von Grenzwerten charakterisiert und untereinander verglichen. Dies ermöglicht eine Anpassung an Betriebsvorgaben des Netzes und Fehlerbedingungen.

Das Verfahren erkennt den Zeitbereich, in dem der Erdschluss erloschen ist und kennzeichnet die dazugehörigen Scheitelwerte und Zeitpunkte. Transiente Scheitelwerte werden durch Grenzwerte ausgeschlossen. Die Nullsystem-Spannung wird als Zeitverlauf verwendet. Anti-Aliasing-Filter und weitere Filter sind anwendbar. Das Verfahren ist für verschiedene Abtastfrequenzen geeignet; auf Transformationen der Signale kann verzichtet werden.

Das Verfahren basiert auf einer analytischen Gleichung, die den Ausschwingvorgang der Nullspannung gesichert beschreibt. Durch Ermittlung der Zeitkonstante $\tau$ wird das Verfahren selbstständig auf das aktuelle Netz und dessen Parameter angepasst. Die Zeitkonstante $\tau$ beinhaltet bereits die Dämpfung $d$ und Verstimmung $v$ des Netzes. Mittels Zeitkonstante $\tau$ wird die Hüllkurve bestimmt. Die Hüllkurve ist deckungsgleich der Scheitelwerte des Ausschwingvorganges. Eine Abweichung ist ein Indiz für eine Wiederzündung. Schwebungen der Nullspannung, etwa durch Überlagerung mit einer Asymmetrie, werden ausgeblendet. Die Nachbildung der Nullspannung als Cosinus-Verlauf unter Verwendung der Hüllkurve zeigt bis zur Wiederzündung eine deutliche Übereinstimmung mit der gemessenen Nullspannung; eine Wiederzündung führt zu einer Abweichung.

Die Nachbildung der Nullspannung beginnend vom letzten Scheitelwert vor Zündung kann unter Annahme der Netznennfrequenz durchgeführt werden. Aufgrund des kurzen Betrachtungszeitraumes einer Periode führt der Frequenzfehler zu keiner signifikanten Abweichung. Alternativ kann auch die aktuelle Netzfrequenz oder, falls ermittelt, die Eigenfrequenz der Nullspannung verwendet werden.

Die Betrags-Differenz zwischen nachgebildeter und erfasster Nullspannung wird einem Schwellwert-Vergleich unterzogen. Der Zeitpunkt der Wiederzündung ergibt sich in Abhängigkeit der Größe des Schwellwertes. Für einen bezogenen Schwellwert im Bereich 3 % bis 10 % liefert das Verfahren z.B. eine genaue Zeitangabe. Das Verfahren erkennt den aktiven Erdschluss eines intermittierenden Fehlers beginnend vom ermittelten Zündzeitpunkt bis maximal zum Beginn des Ausschwingvorgangs und kennzeichnet den Zeitbereich.

**Figur** 1 zeigt einen Schwingungsverlauf 100 einer Nullspannung über die Zeit mit einem Scheitelwert-Bereich 110 und einem anomalen Ereignis, gemäß einem exemplarischen Ausführungsbeispiel der Erfindung. Die Nullspannung uo ist normiert im Bereich 0 bis 1 p.u. Der Scheitelwert-Bereich 110 weist eine Mehrzahl von Scheitelwerten auf, welche zeitlich aufeinander folgen und hierbei absteigend/abfallend sind. Der erste Scheitelwert 111 ist hier als Scheitel m gekennzeichnet. Die drei folgenden Scheitelwerte 113, 114, 116 sind im Vergleich zu dem ersten Scheitelwert 111 abfallend. Hier liegt ein Ausschwingvorgang vor. Der zweite Scheitelwert 112, hier als Scheitel n gekennzeichnet, ist niedriger als die anderen Scheitelwerte 111, 113, 114, 116 des Ausschwingvorgangs. Der dritte Scheitelwert 115 ist hier gekennzeichnet als Scheitel i und unterbricht mit einem anomalen Ereignis den Ausschwingvorgang.

**Figur** 2 zeigt eine einhüllende Kurve 120, die bezüglich des Scheitelwert-Bereichs 110 bestimmt wird, gemäß einem exemplarischen Ausführungsbeispiel der Erfindung. In diesem Beispiel ist die einhüllende Kurve als Gerade dargestellt, die den ersten Scheitelwert 111 und den zweiten Scheitelwert 112 miteinander verbindet. Die einhüllende Kurve 120 verbindet hierbei auch die dazwischen angeordneten Scheitelwerte 113, 114, 116. Der dritte Scheitelwert 115 wird bei dem Bestimmen der einhüllenden Kurve 120 nicht verwendet.

**Figur** 3 zeigt das Bestimmen eines theoretischen Schwingungsverlaufs 140 basierend auf der einhüllenden Kurve 120, gemäß einem exemplarischen Ausführungsbeispiel der Erfindung. Im Gegensatz zu den Figuren 1 und 2 ist der Schwingungsverlauf der Nullspannung auf den Bereich 1 bis -1 p.u. normiert, so dass abwechselnd Maxima und Minima vorliegen. Entsprechend können zwei einhüllende Kurven 120, 120' verwendet werden, die erste einhüllende Kurve 120 verbindet die Maxima und die zweite einhüllende Kurve 120' verbindet die Minima. In diesem Beispiel werden zwar nur zwei Scheitelwerte, der erste Scheitelwert 111 und der zweite Scheitelwert 112, verwendet, jedoch können beide jeweils als Maximum und Minimum verwendet werden.

Der theoretische Schwingungsverlauf des dritten Scheitelwerts 115 ergibt sich z.B. aus einem berechneten harmonischen Verlauf basierend auf den einhüllenden Kurven 120, 120'. Es kann der Figur 3 aber deutlich entnommen werden, dass sich dieser theoretische Schwingungsverlauf von dem tatsächlichen (gemessenen) Schwingungsverlauf 130 des dritten Scheitelwerts 115 unterscheidet. Die Abweichung zwischen dem theoretischen Verlauf 140 und dem tatsächlichen Verlauf 130 kann entsprechend bestimmt werden. Insbesondere ist zwischen dem Ende des Schwingungsverlaufs des zweiten Scheitelwerts 112 und dem Beginn des Schwingungsverlauf des dritten Scheitelwerts 115 ein Ausschlag zu erkennen. An diesem Punkt kann die Abweichung erstmals einen Grenzwert überschreiten, so dass der Beginn des anomalen Ereignisses exakt festgestellt werden kann.

**Figur 4** zeigt einen Schwingungsverlauf 100 einer Nullspannung mit definierten Zeitbereichen 101, 102 anomaler Ereignisse, gemäß einem exemplarischen Ausführungsbeispiel der Erfindung. In diesem Schwingungsverlauf 100 wurden zwei Zeitbereiche 101, 102 identifiziert, in denen jeweils ein anomales Ereignis stattfindet. Basierend auf der oben beschriebenen Evaluation wurden die exakten Zeitpunkte 150, 151 bestimmt, an denen diese Ereignisse begonnen haben. In dem gezeigten Beispiel handelt es sich um Wiederzündungen eines Erdschlusses.

Es sei darauf hingewiesen, dass der Begriff "aufweisend" andere Elemente oder Schritte nicht ausschließt und die Verwendung des Artikels "ein" eine Vielzahl nicht ausschließt. Auch Elemente, die in Verbindung mit verschiedenen Ausführungsformen beschrieben werden, können kombiniert werden. Es ist auch darauf hinzuweisen, dass Bezugszeichen in den Ansprüchen nicht so ausgelegt werden sollten, dass sie den Umfang der Ansprüche einschränken.

Unabhängig vom grammatikalischen Geschlecht eines bestimmten Begriffs sind Personen männlicher, weiblicher oder anderer Geschlechteridentität mit umfasst.

**Patentansprüche**

1. Ein Verfahren zum Evaluieren eines anomalen Ereignisses (150) bezüglich einem Schwingungsverlauf (100), das Verfahren aufweisend:

   Definieren eines Zeitbereichs des Schwingungsverlaufs (100), der einen Scheitelwert-Bereich (110) aufweist, welcher beinhaltet:

   einen ersten Scheitelwert (111),
   einen zweiten Scheitelwert (112), der zeitlich auf den ersten Scheitelwert (111) folgt und im Vergleich zu dem ersten Scheitelwert abfallend ist, und
   einen dritten Scheitelwert (115), der zeitlich auf den zweiten Scheitelwert (112) folgt und im Vergleich zu dem zweiten Scheitelwert (112) ansteigend ist;

   Bestimmen eines theoretischen Schwingungsverlaufs (140) bezüglich des dritten Scheitelwertes (115) basierend auf dem Scheitelwert-Bereich (110),
   insbesondere basierend auf einer bezüglich dem Scheitelwert-Bereich (110) definierten einhüllenden Kurve (120);
   Vergleichen des theoretischen Schwingungsverlaufs (140) mit dem tatsächlichen Schwingungsverlauf (130) bezüglich dem dritten Scheitelwert (115), um eine Abweichung zu ermitteln; und
   Evaluieren des anomalen Ereignisses (150) bezüglich dem Schwingungsverlauf (100) basierend auf der ermittelten Abweichung.

2. Das Verfahren gemäß Anspruch 1, wobei das Evaluieren aufweist:
   Vergleichen der ermittelten Abweichung mit einem Schwellwert, insbesondere Grenzwert.

3. Das Verfahren gemäß Anspruch 2, wobei das Evaluieren ferner aufweist:
   Bestimmen eines Zeitbereichs, insbesondere Zeitpunkts, an dem die ermittelte Abweichung den Schwellwert übersteigt, als Beginn des anomalen Ereignisses (150).

4. Das Verfahren gemäß einem der vorhergehenden Ansprüche, wobei das Vergleichen aufweist:
   Bilden einer Differenz zwischen dem theoretischen Schwingungsverlauf (140) und dem tatsächlichen Schwingungsverlauf (130).

5. Das Verfahren gemäß einem der vorhergehenden Ansprüche,

   wobei die Schwingungskurve (100) eine elektrische Größe betrifft,
   insbesondere wobei die elektrische Größe eine Nullspannung aufweist.

6. Das Verfahren gemäß einem der vorhergehenden Ansprüche,
   wobei der tatsächliche Schwingungsverlauf (130) gemessen, insbesondere experimentell bestimmt, wird.

7. Das Verfahren gemäß einem der vorhergehenden Ansprüche,
   wobei der theoretische Schwingungsverlauf (140) und der tatsächliche Schwingungsverlauf (130) eine Steigung betreffen.

8. Das Verfahren gemäß einem der vorhergehenden Ansprüche,

   wobei der erste Scheitelwert (111) und der zweite Scheitelwert (112) Teil eines Ausschwingvorganges sind,

insbesondere wobei der dritte Scheitelwert (115) den Ausschwingvorgang unterbricht.

9. Das Verfahren gemäß einem der vorhergehenden Ansprüche,
   wobei der Scheitelwert-Bereich (110) eine Mehrzahl von in zeitlicher Reihenfolge abfallender Scheitelwerte (113, 114, 116, 117) aufweist.

10. Das Verfahren gemäß einem der vorhergehenden Ansprüche,

    wobei das Definieren der einhüllenden Kurve (120) bezüglich des ersten Scheitelwerts (111) und des zweiten Scheitelwerts (112) durchgeführt wird,
    insbesondere frei von dem dritten Scheitelwert (115) ist.

11. Das Verfahren gemäß einem der vorhergehenden Ansprüche, wobei das Bestimmen des theoretischen Schwingungsverlaufs (140) aufweist:
    Berechnen eines harmonischen Verlaufs zeitlich nach dem zweiten Scheitelwert (112),
    insbesondere wobei zumindest eine der folgenden Frequenzen zum Berechnen verwendet wird: Netzfrequenz, Netznennfrequenz, Eigenfrequenz der Nullspannung.

12. Das Verfahren gemäß einem der vorhergehenden Ansprüche,

    wobei das anomale Ereignis (150) ein Fehlstrom-Ereignis, insbesondere ein Erdschluss-Ereignis, weiter insbesondere ein Wiederzündung-Ereignis, aufweist;
    insbesondere wobei das Verfahren aufweist: Ermitteln einer Mehrzahl von aufeinanderfolgenden Wiederzündungs-Ereignissen (150, 151), insbesondere deren Zeitpunkten (101, 102).

13. Das Verfahren gemäß einem der vorhergehenden Ansprüche,
    wobei das Verfahren bezüglich einer Erdung, insbesondere einer Sternpunkt-Erdung, weiter insbesondere einer Resonanz-Sternpunkt-Erdung, verwendet wird.

14. Eine Vorrichtung zur Datenverarbeitung, die eingerichtet ist das Verfahren nach einem der vorhergehenden Ansprüche 1 bis 13 auszuführen.

15. Eine Energievorrichtung (200), insbesondere aufweisend ein Schutzgerät, die zumindest eine Vorrichtung zur Datenverarbeitung gemäß Anspruch 14 aufweist.

## FIG 1

## FIG 2

**FIG 3**

bezogene Spannung $u_Q$ in p.u.

Zeit t in ms

**FIG 4**

bezogene Spannung $u_Q$ in p.u.

Zeit t in ms

## FIG 5

## FIG 6

## FIG 7

## FIG 8

Nullspannung $u_0$ in p.u. — $e^{(-\delta \cdot t)}$ — $u_0$ — Zeit t in s

## FIG 9

Leiter-Erde-Spannung $u_{pea}$ in p.u. — Zeit t in s

FIG 10

FIG 11

FIG 12

FIG 13

Europäisches
Patentamt
European
Patent Office
Office européen
des brevets

# EUROPÄISCHER RECHERCHENBERICHT

Nummer der Anmeldung

EP 24 19 5175

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | DE 103 02 451 B3 (EDC GMBH [DE]) 15. Juli 2004 (2004-07-15) * Abbildungen 1-10 * * Absatz [0011] - Absatz [0036] * * Ansprüche 1,3 * ----- | 1-15 | INV. G01R31/52 |
| A | EP 3 879 280 B1 (SPRECHER AUTOMATION GMBH [AT]) 19. Juli 2023 (2023-07-19) * Absatz [0005] - Absatz [0011] * * Abbildungen 1-2 * ----- | 1-15 | |

RECHERCHIERTE
SACHGEBIETE (IPC)

G01R
G01F

Der vorliegende Recherchenbericht wurde für alle Patentansprüche erstellt

| Recherchenort | Abschlußdatum der Recherche | Prüfer |
|---|---|---|
| München | 24. Januar 2025 | Sedlmaier, Stefan |

KATEGORIE DER GENANNTEN DOKUMENTE

X : von besonderer Bedeutung allein betrachtet
Y : von besonderer Bedeutung in Verbindung mit einer
     anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
     nach dem Anmeldedatum veröffentlicht worden ist
D : in der Anmeldung angeführtes Dokument
L : aus anderen Gründen angeführtes Dokument

.......................................................................................
& : Mitglied der gleichen Patentfamilie, übereinstimmendes
     Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 19 5175

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-01-2025

| Im Recherchenbericht angeführtes Patentdokument | Datum der Veröffentlichung | Mitglied(er) der Patentfamilie | Datum der Veröffentlichung |
|---|---|---|---|
| DE 10302451 B3 | 15-07-2004 | KEINE | |
| EP 3879280 B1 | 19-07-2023 | AT 523595 A1 | 15-09-2021 |
|  |  | EP 3879280 A1 | 15-09-2021 |

EPO FORM P0461

Für nähere Einzelheiten zu diesem Anhang : siehe Amtsblatt des Europäischen Patentamts, Nr.12/82